# EUROPEAN PATENT APPLICATION

(11) **EP 1 941 981 A1**
(43) Date of publication of application: **09.07.2008**
(21) Application number: 06822300.7
(22) Date of filing: 26.10.2006
(51) Int. Cl.: B28D 5/00, C03B 33/02, C03B 33/027, C03B 33/09, C30B 29/06, C30B 33/00, H01L 21/301

(54) **METHOD OF FORMING SCRIBE LINE ON SUBSTRATE OF BRITTLE MATERIAL AND SCRIBE LINE FORMING APPARATUS**

(30) Priority: 28.10.2005 JP 2005313931
(71) Applicant: Mitsuboshi Diamond Industrial Co., Ltd., Suita-city, Osaka 564-0044 (JP)
(72) Inventor: SOYAMA, Masanobu, Suita-city Osaka 5640044 (JP)
(74) Representative: TBK-Patent
(86) International application number: PCT/JP2006/321324
(87) International publication number: WO 2007/049668

(57) **Abstract**

A method and an apparatus for creating a scribe line are provided, so that a brittle material substrate can be divided into pieces along highly straight scribe lines.

The surface of a brittle material substrate is heated with a laser beam along a line along which a scribed line is created at a temperature lower than the point at which the brittle material substrate softens, and the heated region is cooled immediately after heating so that a first crack is created, and after that, a cutter is moved over the surface of the substrate in a pressed state along the scribe line, and thus, a crack which is deeper than the first crack is created in the substrate.

## Description

### Technical Field

The present invention relates to a method for creating a scribe line on a substrate when a single substrate made of a brittle material, such as glass, ceramic, which is a sintered material, single crystal silicon, semiconductor wafer or ceramic substrate, or a mother substrate made of single substrates which are pasted together, mainly, is cut.

### Background Technology

In general, in the case where a brittle material substrate, such as a glass substrate, is cut, a method for cutting a substrate according to which a rotational blade, such as a cutter wheel, is rolled over the surface of the substrate and a crack is created along the line in the direction of the thickness, and thus the substrate is cut, is widely used. When a scribe line is created with a cutter wheel, the cutter wheel is rolled over the surface of the brittle substrate while pressing with a strong force in order to create the scribe line, and therefore, various inconveniences are sometimes caused. When a scribe line is created with a cutter wheel, for example, a horizontal crack is sometimes created in addition to a vertical crack which runs in the direction of the thickness. As this horizontal crack is created, cullet is created in the vicinity of the scribe line. In the case where a number of scribe lines are created in a brittle material substrate (mother substrate) having large dimensions in order to create a number of small substrates, the amount of created cullet increases as the total length of the scribe lines created by the cutter wheel increases. As a result, culet which is scattered on the table of the scribing apparatus or the breaking apparatus used after the creation of scribe lines must be cleaned frequently.
In addition, when the created cullet gets into the rotating portion which supports the rotation of the wheel blade around the axis, wear of the rotating portion accelerates and the rotation of the axis support is not smooth, and thus wear of the blade accelerates, and as a result, the life of the cutter becomes shorter.
In order to avoid these inconveniences, a method for creating a scribe line using a laser beam, as shown in, for example, Patent Documents 1 to 3, has been put into practice.
Patent Document 1: Published Japanese Translation of PCT International Unexamined Patent Publication H8 (1996)-509947
Patent Document 2: Japanese Unexamined Patent Publication 2001-58281
Patent Document 3: Japanese Unexamined Patent Publication 2001-130921

### Disclosure of the Invention

### Problem to Be Solved by the Invention

In the case of laser scribing as that described above, cullet is created only when the initial crack (trigger) is created at an end of the substrate with a cutter wheel, and thus, the amount of created cullet can be reduced in comparison with when scribe lines are created using a cutter wheel. In addition, the numeral value for the strength on the end surfaces after breaking using a breaking apparatus can be made higher.
Meanwhile, there may be cases where the crack created in the vicinity of the surface of a brittle material substrate is shallow after laser scribing, depending on the history of the brittle material substrate which is the object to be processed in terms of thermal processing, the state on the surface, the material, the internal structure of the cell gap, in the case of a cell substrate, and the like, and a problem may arise, such that the breaking operation becomes unstable and it is difficult to expect the quality on the cut surfaces after breaking to be stable. Furthermore, when a second scribe line is created in a second direction so as to cross the first scribe line in a first direction that has already been created in a cross scribing operation, the vertical crack that has been created up to that point stops in the vicinity of the intersection, and a problem may be caused with the creation of the scribe line afterwards.
In addition, when the vertical crack is shallow, it becomes necessary to apply a large load to the substrate in the subsequent breaking process, and thus, the apparatus becomes large in scale and a problem arises with the quality of the cut surfaces after breaking.

Such products as displays for personal computers and flat TV's where a flat display is used which have a screen of which the display area is large in scale are preferred, and as a result, mother substrates tend to have a greater area, and it is required for the straightness of the created scribe lines to be much more stable. In addition, the substrates of portable terminal apparatuses (PDA's), such as portable phones and game consoles, are required to be thinner because they are portable, and such quality as to have higher strength on the end surfaces is required. Under present circumstances, conventional scribing using a blade and methods for scribing using a laser are unable to meet requirements in the market, and thus, cannot meet with the strict requirements for the various qualities described above.
Therefore, a main object of the present invention is to provide a method where both laser scribing and scribing with a cutter are used so that the characteristics of the two are combined in the best manner, that is to say, a method for creating a scribe line on a brittle substrate material where the line along which the substrate is scribed is scribed with a laser, and after that, the scribe line is traced with a cutter so that the vertical crack becomes deep, and thus the straightness is high and excellent cut surfaces are provided, as well as an apparatus for use in this method.

### Means for Solving Problem

In order to achieve the above described object, the present invention provides the following technical means. That is to say, the method for creating a scribe line on a brittle material substrate according to the present invention is characterized by being provided with the step of heating the surface of a brittle material substrate along a line along which a scribe line is created at a temperature lower than the point at which the above described brittle material substrate softens; the step of creating a crack having a first depth by cooling the heated region immediately after heating; and the subsequent step of creating a second crack which is deeper than the first depth within the substrate by moving a cutter over the surface of the substrate along the scribe line in a pressed state.

In addition, the apparatus for creating a scribe line on a brittle material substrate according to the present invention is formed so as to be provided with: a fist crack creating means made up of a laser beam scanning means for scanning the surface of a brittle material substrate along a line along which a scribe line is created with a laser beam while heating the substrate with the laser at a temperature lower than the point at which the above described brittle material substrate softens, and a cooling means for cooling the heated region immediately after heating using said laser beam; and a means for moving a cutter in a pressed state for moving a cutter along the scribe line in a pressed state so that a crack which is deeper than the first crack is created in the substrate.

Here, a laser beam as those usually used for scribing a brittle material substrate may be used, and it is preferable to use such laser beams as excimer lasers, YAG lasers, carbonic acid gas lasers or carbon monoxide lasers. In particular, it is preferable to use a carbonic acid gas laser, due to the high efficiency in terms of energy absorption and for economical reasons.

### Effects of the Invention

According to the present invention, as described above, the substrate is cooled after being irradiated with a laser beam, and after that, the crack is deepened using a cutter, and therefore, the brittle material substrate is divided with precision, providing high quality on the cut surfaces, and at the same time, the substrate can be easily broken with a light load. In addition, the cutter is moved over the surface of the substrate in a pressed state after laser scribing, and therefore, a crack which is deeper than cracks created only through laser scribing can be created with a light load for pressing, and excellent effects can be gained, such that microscopic glass cullet is prevented from being created, and thus, various problems can be avoided, and at the same time, the wear of the cutter can be reduced, so that the life is prolonged and the cost is reduced.
In this manner, when a scribe line is created through the combination of a laser scribing operation and movement of a cutter in a pressed state, effects are gained, such that defects can be reduced in the case where only a laser scribing operation is carried out, and the advantages of the laser scribing operation can be increased through the movement of the cutter in a pressed state. Concretely, a highly straight scribe line is created with little cullet created through the initial laser scribing, and after that, a load is applied to this scribe line with a cutter so that the depth of the crack, which is shallow after only laser scribing, can be increased and a deeper crack gained, and thus, specific effects which cannot be observed in the prior art can be gained, such that stability is secured in the breaking operation, which contributes to maintaining high quality on the cut surfaces after breaking. In addition, the means for pressing the substrate with a cutter also works as a means for creating an initial crack, and therefore, no additional apparatus is necessary.
Furthermore, in an electrode terminal process for a liquid crystal panel, for example, usually scribe lines are created with a blade, and then so-called marginal portions are cut off using a breaking machine, and breaking cannot be carried out with precision, due to the small width of the marginal portions, but breaking can be carried out with precision according to the present invention. In addition, a deep crack can be created with a blade through laser scribing without reducing the speed of scanning with the laser, and therefore, effects can be gained, such that liquid crystal panels can be mass produced without changing the so-called tact time.

(Means for Solving Other Problems and Effects)
According to the above described invention, it is preferable for the above described cutter to be formed as a rotating blade which rolls over a brittle substrate, such as a cutter wheel.
As a result, the cutter in wheel form can be rolled over a brittle material substrate, and thus, a deeper crack can be created.

In addition, according to the above described invention, it is possible to form a cutter as a non-rotational blade which slides over a brittle material substrate.
As a result, the structure of the cutter portion can be a simple mechanism, and formed at low cost.

The means for moving a cutter in a pressed state can also be used as a means for creating an initial crack (trigger), and thus, the apparatus can be simplified, and in addition, panels of which the specifications have been changed so that the conditions for scribing are greatly different can be dealt with by switching the program.

### Brief Description of the Drawings

Fig 1 is a schematic diagram showing the configuration of the apparatus or creating a scribe line according to the present invention as viewed from the front;
Fig 2 is a schematic perspective diagram showing the apparatus of Fig 1 in the state before a scribe line is created and illustrating the operation for creating a scribe line;
Fig 3 is a schematic perspective diagram as that in Fig 2 illustrating the first step in the operation of the apparatus;
Fig 4 is a schematic perspective diagram as that in Fig 2 illustrating the second step in the operation:
Figs 5(a) to 5(c) are enlarged cross sectional diagrams schematically showing the process through which a crack is created on a substrate; Fig 5(a) is an enlarged cross sectional diagram showing the stage where a blind crank is created through laser scribing, Fig 5(b) is an enlarged cross sectional diagram showing the stage where a cutter is moved in a pressed state after laser scribing, and Fig 5(c) is an enlarged cross sectional diagram showing the final state of the scribe line after the completion of the movement of the cutter;
Fig 6 is a diagram showing the configuration of the apparatus for creating a scribe line according to another embodiment of the present invention;
Figs 7(a) to 7(d) are cross sectional photographs showing a scribe line created using the apparatus for creating a scribe line of Fig 1; and
Figs 8(a) to 8(d) are plan photographs showing a scribe line created using the apparatus for creating a scribe line of Fig 1.

### Explanation of Symbols

- A: glass substrate (brittle material substrate)
- L1: line along which scribe line is created
- L2: scribe line
- S1: laser spot
- S2: cooled spot
- 14: optical holder
- 16: cooling nozzle
- 18: cutter wheel

### Best Mode for Carrying Out the Invention

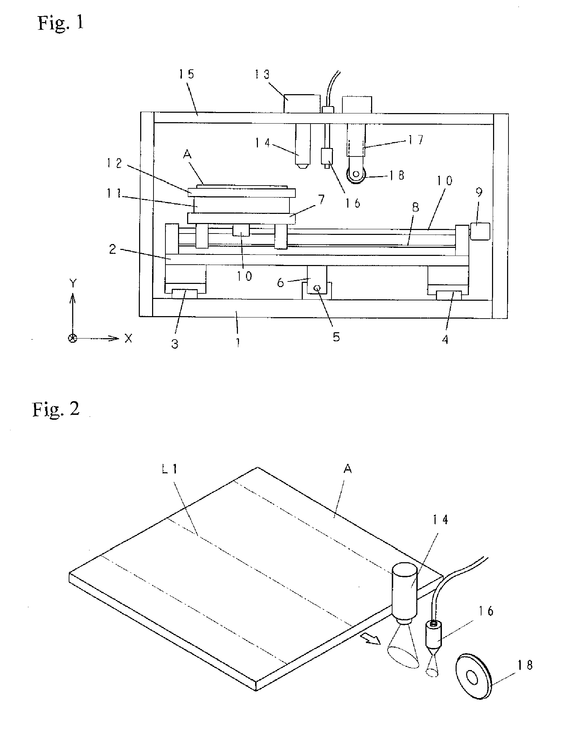

In the following, the present invention is described in detail in reference to the drawings. Fig 1 is a schematic diagram showing the configuration of the apparatus for creating a scribe line according to one embodiment of the present invention as viewed from the front. A slide table 2 which reciprocates in the front-rear direction in Fig 1 (hereinafter referred to as Y direction) is provided along a pair of guide rails 3 and 4 which are placed parallel on a horizontal base 1. A screw 5 is placed in the front-rear direction between the two-guide rails 3 and 4, and this screw 5 is screwed into a stay 6 which is fixed to the above described slide table 2, and the slide table 2 is formed in such a manner as to reciprocate in the Y direction along the guide rails 3 and 4 when the screw 5 is rotated forward and backward by a motor (not shown).

A horizontal support 7 is arranged on the slide table 2 in such a manner as to reciprocate along a guide rail 8 in the left-right direction in Fig 1 (hereinafter referred to as X direction). A screw 10 which is rotated by a motor 9 penetrates through and is screwed into a stay 10 which is fixed to the support 7 so that the support 7 reciprocates in the X direction along the guide rail 8 when the screw 10 rotates forward and backward.

A rotational table 12 which is rotated by a rotation mechanism 11 is provided on the support 7, and a brittle material substrate A, such as a glass substrate, which is an object to be cut (hereinafter simply referred to as glass substrate) is attached to this rotational table 12 in a horizontal state. The rotation mechanism 11 is formed so as to rotate the rotational table 12 around a vertical axis, and can rotate the table to any rotation angle from the reference point. In addition, the glass substrate A, which is the object to be cut, is fixed to the rotational table 12 by means of, for example, a suction chuck.

An optical holder 14 which is connected to a laser oscillator 13 is supported by an attachment frame 15 above the rotational table. The optical holder 14 makes it so that the laser oscillator 13 radiates an elliptical laser spot S1 which extends in a predetermined direction onto the glass substrate A.

In addition, a cooling nozzle 16 is provided in the attachment frame 15 in close proximity to the optical holder 14. A cooling medium, such as cooling water, H gas or carbonic acid gas, is sprayed against the glass substrate from this cooling nozzle 16. This cooling medium is sprayed in a location in close proximity to an end portion of the laser spot S1 which is radiated onto the glass substrate A by the optical holder 14 in advance in the longitudinal direction so as to create a cool spot S2 on the surface of the glass substrate A.

Furthermore, a cutter wheel 18 for creating a deeper crack in the glass substrate A is attached to the attachment frame 15 via an upward-downward movement adjusting mechanism 17. This cutter wheel 18 is made of sintered diamond or a hard metal, and provided with a ridgeline portion in V form of which the vertex is the blade around the outer periphery, and the path when the blade rotates is along the scribe line created through laser scribing. That is to say, the path when the blade of the cutter wheel 18 rotates is on a line connecting the laser spot S1 which is radiated onto the glass substrate A by the optical holder 14 and the cool spot S2 which is sprayed from the cooling nozzle 16. This cutter wheel 18 is driven by a drive mechanism including a motor, not shown, so that the force pressing against the glass substrate A can be finely adjusted by the upward-downward movement adjusting mechanism 17.

Positioning of the above described slide table 2 and the support 12, control of the laser oscillator 13 and the cooling nozzle 16, and positioning (force pressing against glass substrate A) and rotation control of the cutter wheel 18 are controlled by a computer control portion, not shown.

In the case where a scribe line is created on the glass substrate A using the above described apparatus for creating a scribe line, first, the size of the glass substrate A which is to be divided into pieces of a predetermined size, the location where scribe lines are to be created and the force for pressing the cutter wheel 18 against the glass substrate A are inputted. Then, the glass substrate A is fixed to the rotational table 12 using, for example, a suction means. After that, the glass substrate A is moved in the direction along the line L1 along which a scribe line is created, that is to say, in the direction to the right from the location in Fig 1, relative to the attachment frame 15 together with the slide table 2. At this time, the longitudinal direction of the elliptical laser spot radiated by the optical holder 14 becomes the direction along the line L1 along which a scribe line is formed on the glass substrate A.

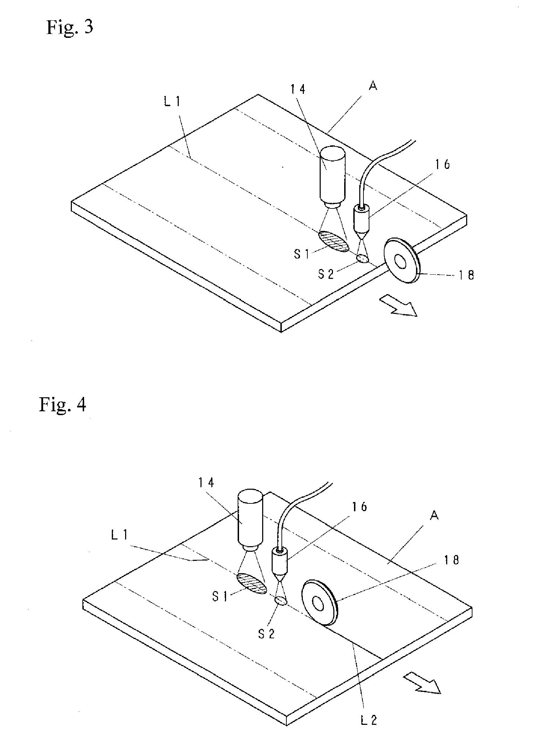

Figs 2 to 4 are schematic perspective diagrams for illustrating the operation for creating a scribe line on the glass substrate A; Fig 2 shows the state before a scribe line is created. The location of the glass substrate A in this Fig 2 corresponds to the location of the glass substrate in Fig 1. First, the glass substrate A is moved from the location in Fig 2 until the end is located beneath the cutter wheel 18, the cutter wheel 18 is lowered by the upward-downward movement adjusting mechanism 17, and the glass substrate A is moved slightly in the direction of the arrow while the end of the glass substrate A makes contact with the cutter wheel so that an initial crack is created at the end of the glass substrate A. After that, the glass substrate A is once returned to its original location (location in Fig 2), and the glass substrate A is again moved in the direction of the arrow so that the elliptical laser spot S1 is radiated along the line L1 along which a scribe line is formed, as shown in Fig 3.

The design is such that the laser spot S1 is a long ellipsis having, for example, a long diameter of 30.0 mm and a short diameter of 1.0 mm, and the long axis coincides with the line L1 along which a scribe line is created. In addition, the temperature at which the laser spot S1 is heated is set to a temperature lower than the point at which the glass substrate A softens. As a result, the surface of the glass substrate A which is irradiated with the laser spot S1 is heated without melting.

The glass substrate A is further slid in the direction of the arrow, and a cooling medium is sprayed from the cooling nozzle 16. This cooling medium is sprayed along the line L1 along which a scribe line is created with intervals of, for example, 2.5 mm in the direction of the long axis of the radiated laser spot S1. As a result, compression stress is generated in the region heated by the laser spot S1 and tensile stress is generated in the cool spot S2 cooled by the cooling medium. As a result of this effect, microscopic cracks are created in sequence in the glass substrate a along the line L1 along which a scribe line is created.

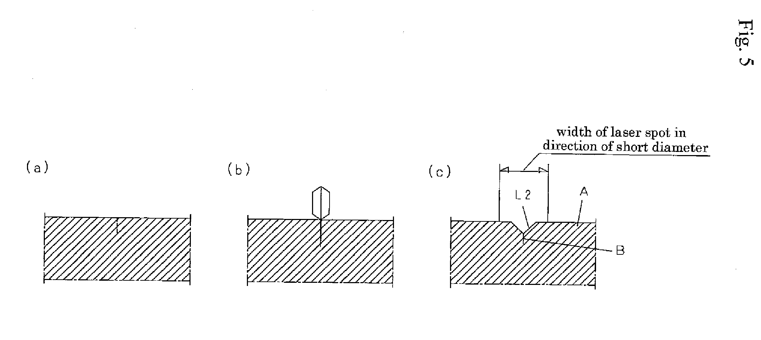

Next, the glass substrate A is slid in the direction of the arrow, and thus, a deeper crack is created using the cutter wheel 18, which rolls along the scribe line on the glass substrate A in a pressed state. It is preferable for the load with which the cutter wheel 18 is pressed against the glass substrate A to be approximately 3 N, as it is possible for such a light load for pressing to create a crack B as that shown in Fig 5(c) in the lower portion of the scribe line L2, so that the substrate can be divided with a light load. A deeper crack is created by means of the cutter wheel 18 and the substrate is cut from this crack when the substrate is cut, and thus, high quality can be gained on the cut surfaces. In addition, even in the case where the cutter wheel is pressed with a load of less than 3 N, a scribe line for changing the plasticity can be created on the surface of the glass substrate, and as a result, this scribe line makes it possible to cut the substrate along a straight line in the same manner as described above. In addition, when the substrate is cut, the substrate can be divided with a light load in comparison with the case where the scribe line is created using only a laser beam.

(Test Examples)

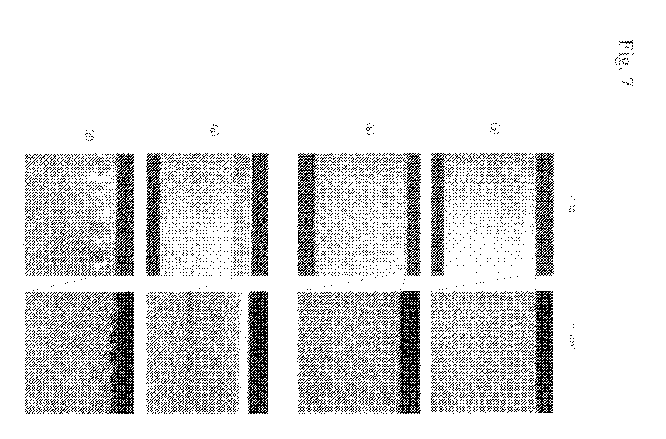

Figs 7(a) to 8(d) are cross sectional photographs and plan photographs showing the state of the scribe lines created under various conditions for pressing with a cutter wheel in the above described apparatus for creating a scribed line. The apparatus used was a type MS500 made by Mitsuboshi Diamond Industrial Co., Ltd., and the cutter wheel used was a type CW-T 2ϕ 120 ° V770 made by Mitsuboshi Diamond Industrial Co., Ltd..
In addition, the substrates used were Eagle 2000 made by Corning Incorporated having a thickness of 0.7 mm.

The cross sectional photograph of Fig 7(a) shows a surface cut only through laser scribing, the cross sectional photograph of Fig 7(b) shows a surface cut through laser scribing and using a cutter wheel with a load for pressing of 2 N, the cross sectional photograph of Fig 7(c) shows a surface cut through laser scribing and using a cutter wheel with a load for pressing of 4 N, and the cross sectional photograph of Fig 7(d) shows a surface cut through laser scribing and using a cutter wheel with a load for pressing of 10 N.
In the figures, ×1000 (right column) means that the surface portion has been enlarged by 1000 and ×200 (left column) means that the surface portion has been enlarged by 200.

It can be seen from the cross sectional photographs that no crack was created in the case where no cutter wheel was used (Fig 7(a)) and the load for pressing with the cutter wheel was 2 N (Fig 7(b)), while a crack was created in the case where the load for pressing with the cutter wheel was 4 N (Fig 7(c)) and 10 N (Fig 7(d)).
Incidentally, in the case where the substrate was cut after being scribed only with a cutter wheel a load for pressing of approximately 7 N was required, and in comparison with this, a crack could be created with a very light load and the substrate broken with a light load. Here, there was a border where a crack started being created in the vicinity of 3 N, though this is not shown in the photographs.

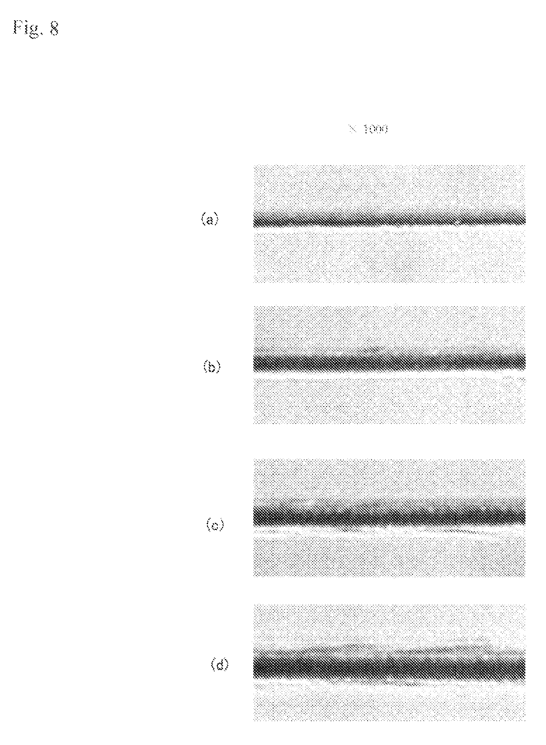

The plan photograph of Fig 8(a) shows a surface cut using a cutter wheel with a load for pressing of 2 N after laser scribing, the plan photograph of Fig 8(b) shows a surface cut using a cutter wheel with a load for pressing of 4 N after laser scribing, the plan photograph of Fig 8(c) shows a surface cut using a cutter wheel with a load for pressing of 6 N after laser scribing, and the plan photograph of Fig 8(d) shows a surface cut using a cutter wheel with a load for pressing of 8 N after laser scribing.
It can be seen from the plan photographs that no crack was created and traces of plastic deformation were created in the case of a load of pressing with a cutter wheel of 2 N (Fig 8(a)). A slight crack started being created in the case of a load of pressing with a cutter wheel of 4 N (Fig 8(b)). A crack was created in the case of a load of pressing with a cutter wheel of 6 N and 8 N (Figs 8(c) and 8(d)).
In addition, as can be seen from Figs 8(a) to 8(d), a straight scribe line without any undulation was created in all cases where a cutter wheel was rolled over the substrate with a load of 2 N to 10 N after laser scribing.

In particular, in the case where a cutter wheel was rolled over the substrate with a low load for pressing, for example when the load for pressing was 2 N (Fig 7(b)), a cut surface which was approximately as good as in the case of only laser scribing was gained, and in addition the substrate could be easily cut along the scribe line.

Here, cases where laser scribing was carried out after scribing with a cutter wheel (that is to say, processes in reverse order) were also examined. In comparison with the above described examples (laser first and cutter wheel second), a problem arose, such that cullet was created, as in the case where scribing was carried out only with a cutter wheel. Furthermore, there was a problem with the straightness of the scribe line in the operation for scribing using a blade, and the depth of the crack was approximately 10 % to 15 % of the brittle material substrate which was the object of processing, and thus, the numeral value for the strength on the end surface, which is used for evaluating the quality of the cut surface after breaking, was inferior in comparison with the case where a scribe line was created using only a laser.

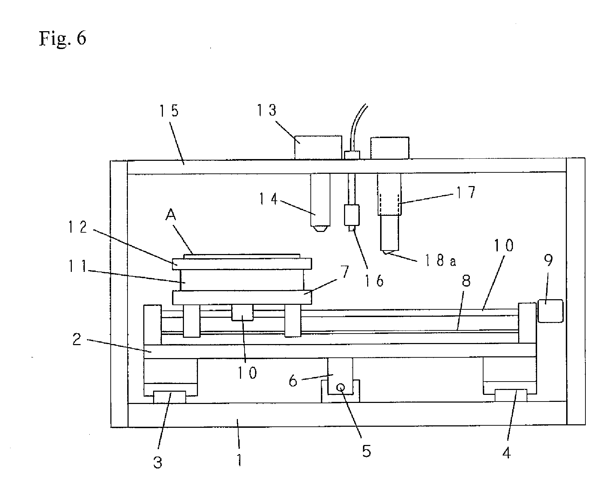

(Other Embodiments)
Though in the above described embodiments, the cutter for creating a scribe line L2 is a rotating blade in wheel form, as shown in Fig 6, it is possible to create the scribe line with a non-rotational blade 18a which slides over the glass substrate A in a set location.

In addition, though in the apparatus shown in the above described embodiment, the glass substrate A is slid relative to the optical holder 14, the cooling nozzle 16 and the cutter wheel 18, it is, of course, possible for the optical holder 14, the cooling nozzle 16 and the cutter wheel 18 to be moved relative to the glass substrate A in the configuration instead.

### Industrial Applicability

The method and the apparatus for creating a scribe line according to the present invention can be used to create a scribe line on glass, ceramic, which is a sintered material, single crystal silicon, semiconductor wafer and ceramic substrate, and in addition, on liquid crystal display substrates, transmission liquid crystal display substrates, organic EL element substrates and PDP (plasma display panel) substrates where glass substrates are pasted together, and reflective liquid crystal display substrates where a glass substrate and a silicon substrate are pasted together.

## Claims

1. A method for creating a scribe line on a brittle material substrate, **characterized by** comprising the steps of: heating a surface of a brittle material substrate with a laser beam along a line along which a scribe line is created at a temperature lower than the point at which said brittle material substrate softens; creating a first crack having a first depth by cooling the heated region immediately after heating; and after that creating a second crack of which the depth is greater than said first depth along said scribe line in the substrate by moving a cutter over the surface of the substrate state along the scribe line in a pressed.

2. The method for creating a scribe line on a brittle material substrate according to Claim 1, wherein said cutter is a rotating blade which is rolled over a surface of the brittle material substrate.

3. The method for creating a scribe line on a brittle material substrate according to Claim 1, wherein said cutter is a non-rotating blade which is slid over a surface of the brittle material substrate.

4. An apparatus for creating a scribe line on a brittle material substrate, **characterized by** comprising: a first crack creating means made up of a laser beam generating means for generating a laser beam along a line along which a scribe line is created on a surface of a brittle material substrate mounted on a table while heating the substrate with the laser at a temperature which is lower than the point at which said brittle material substrate softens, and a cooling means for cooling the heated region immediately after the heating with said laser beam; and a means for pressing with a cutter which is moved along the scribe line in a pressed state after the first crack is created so that a crack which is deeper than the first crack which is created by said first crack creating means is created in said substrate, wherein said first crack creating means and said means for pressing with a cutter are moved relative to the brittle material substrate.

5. The apparatus for creating a scribe line on a brittle material substrate according to Claim 4, wherein said cutter is a rotating blade which is rolled over a surface of the brittle material substrate.

6. The apparatus for creating a scribe line on a brittle material substrate according to Claim 4, wherein said cutter is a non-rotating blade which is slid over a surface of the brittle material substrate.

7. The apparatus for creating a scribe line on a brittle material substrate according to Claim 4, further comprising an attachment frame on which said laser beam generating means, cooling means and means for pressing with a cutter are arranged in a line in this order for scanning.

8. The apparatus for creating a scribe line on a brittle material substrate according to Claim 7, wherein said means for moving a cutter in a pressed state also works as a means for creating an initial crack.
